# EUROPÄISCHE PATENTSCHRIFT

(11) **EP 0 977 042 B1**
(45) Veröffentlichungstag und Bekanntmachung des Hinweises auf die Patenterteilung: **31.08.2005**
(21) Anmeldenummer: 99111234.3
(22) Anmeldetag: 09.06.1999
(51) Int. Cl.: G01R 19/00, G01D 3/02

(54) **Vorrichtung zur Offsetkompensation bei analogen Signalmessungen**
Appliance for offset compensation in analog signal measurement
Dispositif pour la compensation d'offset dans la mesure de signaux analogiques

(30) Priorität: 30.07.1998 DE 19834433
(43) Veröffentlichungstag der Anmeldung: 02.02.2000
(73) Patentinhaber: Delphi Technologies, Inc., Troy, MI 48007 (US)
(72) Erfinder: Engel, Joseph A., 7216 Bereidange (LU)
(74) Vertreter: Manitz, Finsterwald & Partner GbR

(56) Entgegenhaltungen:
- CH-A- 572 219
- BEST R.: "Die Verarbeitung von Kleinsignalen" 1982 , AT VERLAG AARAU , STUTTGART, DE XP000934394 * Seite 59; Abbildung 31 *

## Beschreibung

Die vorliegende Erfindung betrifft eine Vorrichtung zur Offsetkompensation bei analogen Signalmessungen sowie ein Verfahren zum Betreiben einer solchen Vorrichtung.

Bei der Messung von analogen Signalwerten, wie beispielsweise Spannungswerten, treten immer dann Probleme auf, wenn das Bezugspotential des das Meßsignal liefernden Meßwertaufnehmers verschieden von dem Bezugspotential des Meßgerätes ist. Aufgrund der zwischen dem Meßwertaufnehmer und dem Meßgerät bestehenden Potentialdifferenz ist das an dem Meßeingang des Meßgerätes anliegende Meßsignal mit einem Offset behaftet, was insbesondere bei niedrigen Signalwerten oder bei Messungen, die mit hoher Genauigkeit durchgeführt werden müssen, nachteilig ist. Ein typisches Beispiel, bei dem diese Probleme besonders häufig auftreten, ist die Messung von Signalwerten in Kraftfahrzeugen. In Kraftfahrzeugen wird üblicherweise die Fahrzeugkarosserie bzw. der Fahrzeugrahmen als gemeinsame Masse für alle elektrischen Geräte verwendet, wobei hier bei voneinander entfernt angeordneten elektrischen Geräten ein erheblicher Masseversatz auftreten kann, der zu den unerwünschten Potentialdifferenzen führt.

Die durch die Potentialdifferenzen verursachten Offsetsignale können beispielsweise unter Verwendung von Operationsverstärkern kompensiert werden. Die entsprechenden Schaltungen sind jedoch relativ teuer und besitzen eine relativ große Baugröße, was insbesondere im Zuge der zunehmenden Miniaturisierung von elektronischen Bauelementen nachteilig ist.

Es ist eine Aufgabe der Erfindung, eine Vorrichtung der eingangs genannten Art anzugeben, die zum einen kostengünstig herstellbar ist und darüber hinaus eine geringe Baugröße besitzt.

Diese Aufgabe wird erfindungsgemäß gelöst durch eine Vorrichtung zur Offsetkompensation bei analogen Signalmessungen mit einer Meßvorrichtung mit einem Meßsignaleingang zum Messen eines von einem Meßwertaufnehmer gelieferten analogen Signalwertes gegenüber einem Haupt-Bezugspunkt, mit einem Signalwertspeicherelement zum Speichern des zu messenden Signalwertes, wobei das Signalwertspeicherelement einen Meßsignalanschluß und einen Bezugssignalanschluß aufweist und der Meßsignalanschluß mit dem Meßsignaleingang der Meßvorrichtung verbunden und an eine erste, den Signalwert führenden Meßleitung des Meßwertaufnehmers anschließbar ist sowie der Bezugssignalanschluß an eine zweite, mit einem Bezugspunkt des Meßwertaufnehmers verbundene Meßleitung des Meßwertaufnehmers anschließbar ist, mit einem Schalter, über den der Bezugssignalanschluß des Signalwertspeicherelements mit dem Haupt-Bezugspunkt verbindbar bzw. von diesem trennbar ist, und mit einer Steuervorrichtung zum Ansteuern des Schalters.

Bei dem erfindungsgemäßen Verfahren wird der zu messende Signalwert vor dem Meßvorgang in einem Signalwertspeicherelement massefrei gespeichert und während des Meßvorgangs wird das Signalwertspeicherelement gegen Masse gelegt und der gespeicherte Signalwert gemessen.

Die erfindungsgemäße Offsetkompensation umfaßt somit zwei unterschiedliche Abschnitte. In einem ersten Zeitabschnitt wird der zu messende Signalwert massefrei in einem Signalwertspeicherelement gespeichert, wobei aufgrund der massefreien Speicherung die aufgrund von Potentialdifferenzen auftretenden, beschriebenen Probleme nicht zutage treten und somit der unverfälschte, offsetfreie Signalwert gespeichert wird.

Handelt es sich bei dem zu messenden Signal um ein Wechselsignal, so wird fortlaufend der momentane Signalwert gespeichert, so daß in dem Signalwertspeicherelement zu jedem Zeitpunkt ein aktueller Schnappschuß des jeweiligen Signalwertes abgespeichert ist.

Soll nun der Signalwert zu einem bestimmten Zeitpunkt gemessen werden, so wird das Signalwertspeicherelement in einem zweiten Zeitabschnitt gegen das Bezugspotential des verwendeten Meßgerätes geschaltet und von diesem der gespeicherte Signalwert gemessen. Dieser Signalwert entspricht dabei dem Momentanwert des zu messenden Signals unmittelbar vor dem Verschalten des Signalwertspeicherelements mit dem Bezugspotential.

Nach erfolgter Messung wird das Signalwertspeicherelement wieder von dem Bezugspotential getrennt, so daß nachfolgend wieder die von dem Meßwertaufnehmer gelieferten Signalwerte massefrei gespeichert werden.

Bevorzugt ist die Meßvorrichtung als Spannungsmeßvorrichtung und das Signalwertspeicherelement als Kondensator ausgebildet. Gerade im Kraftfahrzeugbereich werden eine Vielzahl von Spannungen von einem zentralen Steuergerät aufgenommen und zur Steuerung des Motors, der Einspritzanlage oder zur Anzeige beispielsweise auf einem Display verwendet.

Nach einer vorteilhaften Ausführungsform der Erfindung ist der Meßsignalanschluß des Signalwertspeicherelements an die den Signalwert führende Meßleitung des Meßwertaufnehmers über einen Widerstand anschließbar. Gleiches gilt für den Bezugssignalanschluß des Signalwertspeicherelements, der vorteilhaft an die mit dem Bezugspunkt des Meßwertaufnehmers verbundene Meßleitung des Meßwertaufnehmers über einen Widerstand anschließbar ist.

Durch diese Widerstände wird ein Entladen des Kondensators während des Meßintervalls verhindert, so daß der Meßvorgang mit ausreichender Genauigkeit durchgeführt werden kann.

Der das Signalwertspeicherelement mit dem Bezugspotential verbindende Schalter ist vorteilhaft als Transistor ausgebildet und kann entweder über eine innerhalb der Vorrichtung zur Offsetkompensation vorgesehene Steuereinheit oder eine separate Steuereinheit angesteuert werden.

Insbesondere bei Ausbildung der Meßvorrichtung und der Steuervorrichtung als Mikroprozessoren kann die Messung und Auswertung der Signalwerte sowie die Ansteuerung des Schalters in einem einheitlichen Mikroprozessor durchgeführt werden.

Typische Anwendungsfälle für die erfindungsgemäße Offsetkompensation ist die Messung von Füllstand, Druck, Temperatur oder Sauerstoffgehalt. So kann beispielsweise in einem Kraftfahrzeug mit der erfindungsgemäßen Vorrichtung sowohl der Treibstoff-, der Brennflüssigkeits-, der Kühlwasser- sowie der Scheibenwaschwasserfüllstand gemessen werden. Weiterhin kann beispielsweise der Sauerstoffgehalt in einer Lambdasonde oder die Temperatur bzw. der Druck des Motoröls offsetfrei gemessen werden.

Erfindungsgemäß können auch mehrere Meßwertaufnehmer und eine entsprechende Anzahl von Signalwertspeicherelementen vorgesehen sein, wobei jeweils mehrere Signalwertspeicherelemente über denselben Schalter mit dem Haupt-Bezugspunkt verbindbar sind. Die gemessenen Signale können dabei entweder einer einzigen Meßvorrichtung mit mehreren Meßsignaleingängen oder unterschiedlichen Meßvorrichtungen zugen zugeführt werden.

Weitere bevorzugte Ausführungsformen der Erfindung sind in den Unteransprüchen beschrieben.

Die Erfindung wird nachfolgend anhand von Ausführungsbeispielen unter Bezugnahme auf die Zeichnungen näher beschrieben; in diesen zeigen:
- Fig. 1: eine Prinzipschaltung einer erfindungsgemäß ausgebildeten Vorrichtung zur Offsetkompensation,
- Fig. 2: die Spannungsverläufe an einzelnen Punkten der Schaltung nach Fig. 1 und
- Fig. 3: eine weitere Ausführungsform der Erfindung.

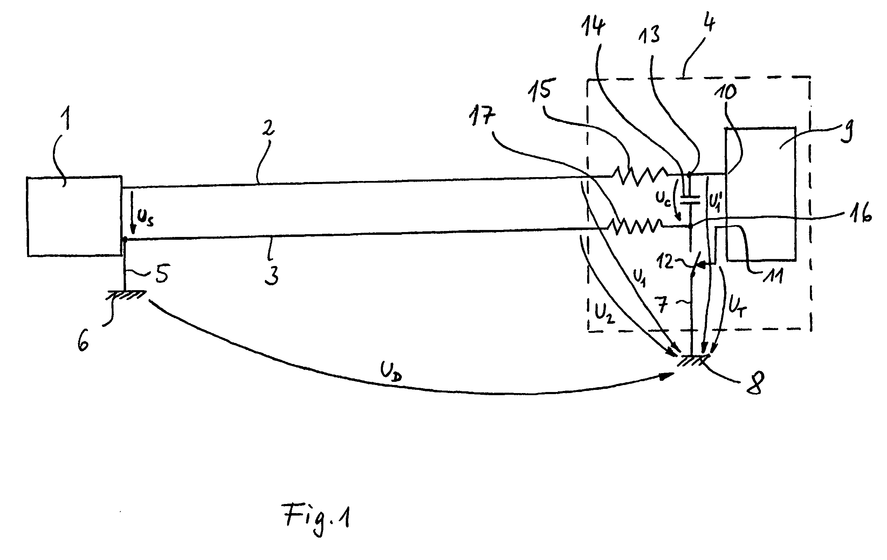

In Fig. 1 ist ein Meßwertaufnehmer 1 über eine erste Meßleitung 2 und eine zweite Meßleitung 3 mit einem Steuergerät 4 verbunden. Der Meßwertaufnehmer 1 kann dabei als Sensor zur Erfassung eines Flüssigkeitsstandes, eines Drucks, eines Sauerstoffgehalts, einer Temperatur oder beliebiger anderer physikalischer Größen ausgebildet sein. Dabei ist es sowohl möglich, daß, wie in Fig. 1 gezeigt, die gemessene physikalische Größe in eine korrespondierende Ausgangsspannung Us umgewandelt wird oder daß, beispielsweise bei einem Temperaturaufnehmer, als Ausgangssignal des Meßwertaufnehmers eine Widerstandsänderung erzeugt wird.

Die zweite Meßleitung 3 ist unmittelbar im Bereich des Meßwertaufnehmers 1 über eine Leitung 5 mit einer Signalmasse 6 verbunden, die bezüglich des Meßsignals Us den Bezugspunkt bzw. das Bezugspotential bildet. Im Falle eines Kraftfahrzeugs handelt es sich bei der Signalmasse 6 dabei beispielsweise um einen Teil der Fahrzeugkarosserie bzw. des Fahrzeugrahmens.

Das Steuergerät 4 ist über eine Leitung 7 mit einer Hauptmasse 8, auch Houpt-Bezugspunkt genannt, verbunden, die zu der Signalmasse 6 einen relativ großen Abstand besitzt. Aufgrund des beispielsweise von der Signalkarosserie gebildeten Widerstandes besteht somit zwischen der Signalmasse 6 und der Hauptmasse 8 eine Potentialdifferenz, die in Fig. 1 durch den Spannungsabfall U_{D} dargestellt ist.

Das Steuergerät 4 umfaßt eine beispielsweise als Mikroprozessor ausgebildete Meßvorrichtung 9, die einen Meßsignaleingang 10 und einen Steuerausgang 11 besitzt. Der Steuerausgang 11 ist mit einem beispielsweise als Transistor ausgebildeten Schalter 12 derart verbunden, daß die Meßvorrichtung 9 durch Anlegen einer Transistorsteuerspannung U_{T} den Schalter 12 ein- bzw. ausschalten kann.

An dem Meßsignaleingang 10 der Meßvorrichtung 9 ist ein Meßsignalanschluß 13 eines als Kondensator ausgebildeten Signalwertspeicherelements 14 sowie ein Widerstand 15 angeschlossen, dessen anderes Ende mit der ersten Meßleitung 2 verbunden ist. Der dem Meßsignalanschluß 13 gegenüberliegende Anschluß des Kondensators 14 bildet einen Bezugssignalanschluß 16, der zum einen über den Schalter 12 und die Leitung 7 mit der Hauptmasse 8 und zum anderen über einen Widerstand 17 mit der zweiten Meßleitung 3 verbunden ist.

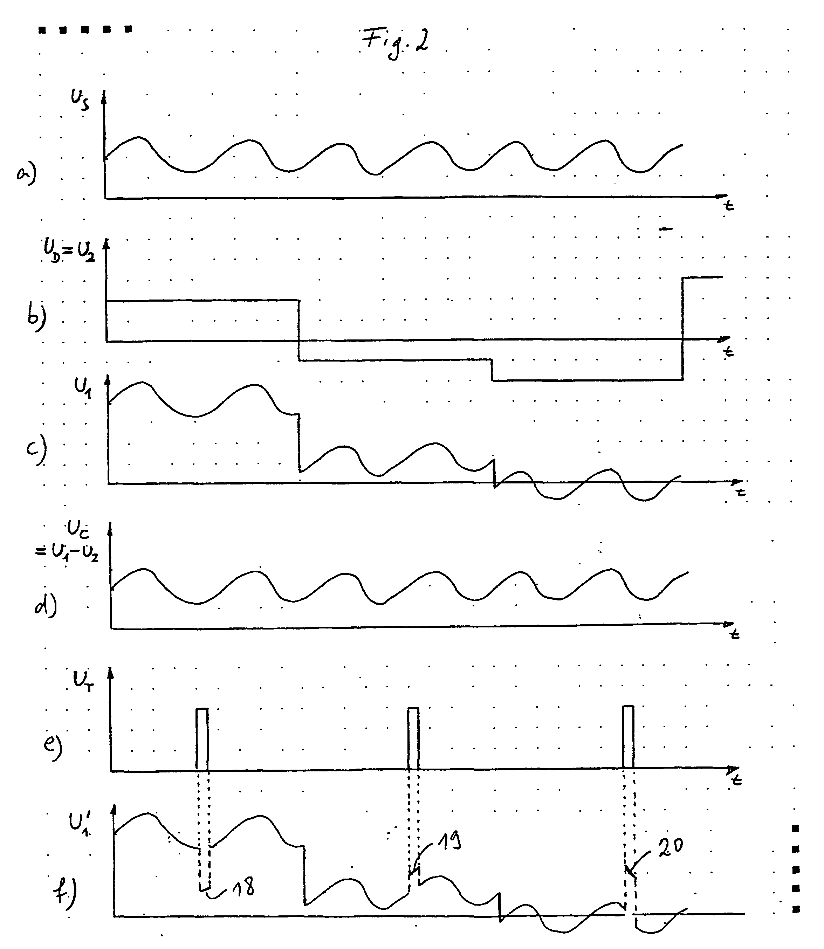

Im folgenden wird anhand der in Fig. 2 dargestellten Signalverläufe die Funktionsweise einer erfindungsgemäß ausgebildeten Vorrichtung näher beschrieben:

In Fig. 2a ist das von dem Meßwertaufnehmer 1 gelieferte Ausgangssignal Us dargestellt. Dabei kann es sich um ein Signal in beliebiger Form, beispielsweise ein Wechselsignal oder ein Gleichsignal handeln.

Fig. 2b zeigt das Signal U_{D}, das aufgrund des Potentialunterschieds zwischen der Signalmasse 6 und der Hauptmasse 8 entsteht. Aufgrund äußerer Gegebenheiten, wie beispielsweise dem Einschalten eines zusätzlichen Stromverbrauchers in ein Kraftfahrzeug, können dabei die Werte des Spannungsabfalls U_{D} variieren, wie es in Fig. 2b dargestellt ist.

Wie weiter aus Fig. 2b ersichtlich ist, ist die zwischen dem Bezugssignaleingang des Steuergeräts 4 und der Hauptmasse 8 liegende Spannung U₂ gleich dem Spannungsabfall U_{D}.

Fig. 2c zeigt die Spannung U₁, wie sie an dem Meßsignaleingang des Steuergeräts 4 gegenüber der Hauptmasse 8 anliegt. Die Spannung U₁ besteht dabei aus der Summe der Meßsignalspannung Uₛ und dem einen Offset bildenden Potentialabfall U_{D}. Würde die Spannung U₁ direkt an der Meßvorrichtung 9 anliegen, so würden deutliche Meßfehler auftreten, wie es aus einem Vergleich der Spannungen Uₛ und U₁ klar ersichtlich ist.

Fig. 2d zeigt die Spannung U_{C}, die an dem Kondensator 14 anliegt. Da die Spannung U_{c} unmittelbar aus der zwischen den Meßleitungen 2, 3 anliegenden Spannung Uₛ ohne Bezugnahme auf die Hauptmasse 8 abgeleitet wird, entspricht die Spannung U_{c} in ihrem Verlauf exakt der Meßsignalspannung Uₛ. Dies ist auch daraus zu erkennen, daß die Spannung U_{c} die Differenz aus den Eingangsspannungen U₁ und U₂ ist, so daß der Offsetanteil U₂ automatisch kompensiert ist.

Fig. 2e zeigt die Transistorsteuerspannung U_{T}, durch die der Schalter 12 ansteuerbar ist. Dabei ist der Schalter 12 während der Zeitdauer der in Fig. 2e dargestellten Pulse geschlossen, wohingegen er während der restlichen Zeit geöffnet ist. Die Pulsdauer der Transistorsteuerspannung U_{T} beträgt dabei beispielsweise 50 µs, während der Abstand zwischen zwei benachbarten Pulsen beispielsweise größer gleich 5 ms sein kann. Grundsätzlich ist die Zeit zwischen den Pulsen deutliche größer als die Pulsdauer, so daß die Pulsdauer beispielsweise nur 1% der Zeitdauer von einem zu dem nächsten Puls beträgt.

Fig. 2f zeigt die an den Meßsignaleingang 10 der Meßvorrichtung 9 liegende reduzierende Spannung U'₁. Es ist zu erkennen, daß bei geschlossenem Schalter 12, d.h. zwischen den Pulsen der Transistorsteuerspannung U_{T} der Spannungsverlauf der Eingangsspannung U'₁ gleich dem Spannungsverlauf der Eingangsspannung U'₁ ist. Die von der Meßvorrichtung 9 während dieser Zeit zwischen dem Meßsignaleingang 10 und der Hauptmasse 8 gemessene Spannung ist somit mit einem Offset behaftet und verfälscht.

Nach Schließen des Schalters 12 liegt zwischen dem Meßsignaleingang 10 und der Hauptmasse 8 die zu diesem Zeitpunkt an dem Kondensator 14 anliegende Spannung U_{c} an, die dem offsetfreien, korrekten Wert der Meßsignalspannung Uₛ entspricht. Diese korrigierten Spannungswerte 18, 19, 20 können jetzt von der Meßvorrichtung 9 aufgenommen und entsprechend ausgewertet werden.

Nach jeweils erfolgter Messung wird der Schalter 12 durch das Transistorsteuersignal U_{T} wieder geöffnet und gleichzeitig oder vorher der Meßvorgang unterbrochen, so daß bis zu dem nächsten Puls des Transistorsteuersignals U_{T} keine Messung vorgenommen wird, sondern lediglich die Meßspannung Uₛ in dem Kondensator 14 kontinuierlich gespeichert wird.

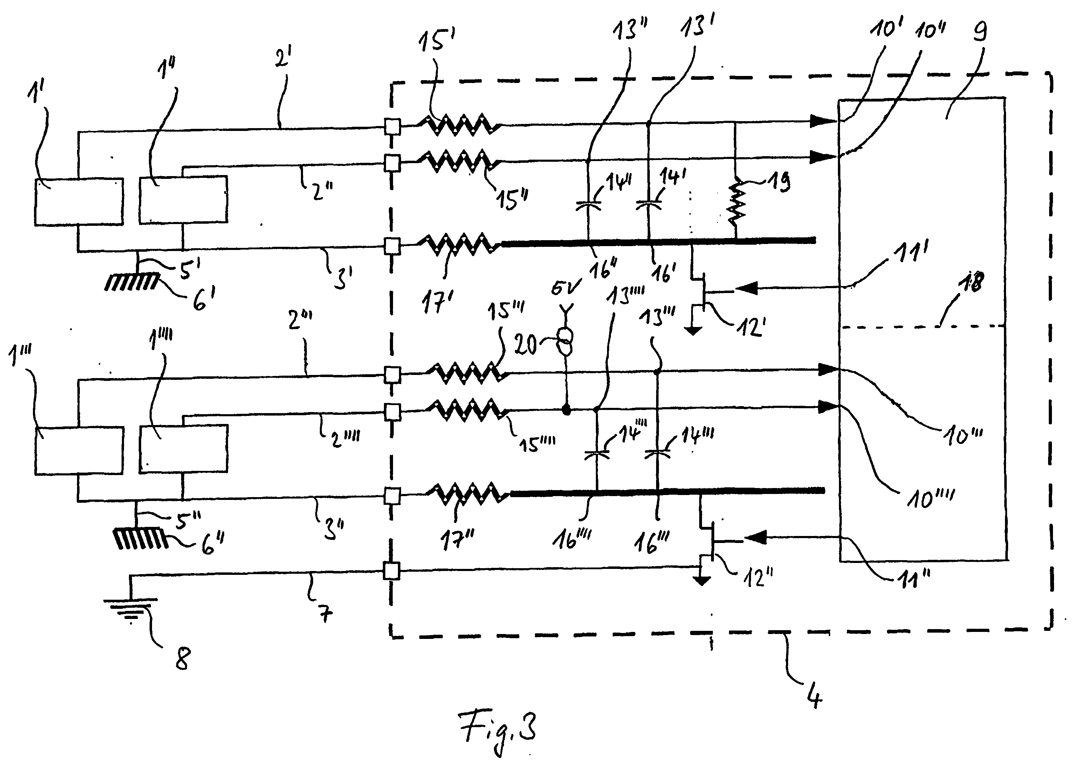

Fig. 3 zeigt ein Ausführungsbeispiel, bei dem mehrere Meßwertaufnehmer 1', 1'', 1''', 1'''' mit einem einheitlichen Steuergerät 4 verbunden sind. Der prinzipielle Aufbau entspricht der Vorrichtung gemäß Fig. 1, so daß entsprechende Elemente mit entsprechenden Bezugszeichen, eventuell versehen mit einem oder mehreren Strichen, versehen sind. Aus Fig. 3 ist zu erkennen, daß jeweils die Meßwertaufnehmer 1' und 1'' sowie die Meßwertaufnehmer 1''' und 1'''' an jeweils derselben Signalmasse 6' bzw. 6" angeschlossen sind und somit jeweils mit dem gleichen Offset beaufschlagt sind. Demgemäß können die jeweils von den Meßwertaufnehmern 1' und 1'' bzw. von den Meßwertaufnehmern 1''' und 1'''' gelieferten Meßsignale über jeweils einen gemeinsamen Schalter 12' bzw. 12" zur Offsetkompensation angesteuert werden.

Für jeden der Meßwertaufnehmer 1', 1'', 1''', 1'''' ist ein eigener Kondensator 14', 14'', 14''', 14"" vorgesehen, der jeweils den Signalwertverlauf der Ausgangssignale der Meßwertaufnehmer 1', 1", 1''', 1'''' kontinuierlich speichert, während die Schalter 12', 12" geöffnet und somit die Kondensatoren 14', 14", 14''', 14'''' massefrei geschaltet sind.

Die Meßvorrichtung 9 umfaßt in diesem Fall vier Meßsignaleingänge 10', 10'', 10"', 10"", mit denen jeweils unabhängig voneinander die von den Meßwertaufnehmern 1', 1", 1''', 1"" erzeugten Signale aufgenommen werden können. Weiterhin umfaßt die Meßvorrichtung 9 zwei Steuerausgänge 11', 11'', mit denen jeweils die Schalter 12', 12'' unabhängig voneinander angesteuert werden können.

Wie in Fig. 3 durch eine gestrichelte Linie 18 angedeutet ist, kann auch für jeweils an einer Signalmasse 6', 6'' angeschlossene Meßwertaufnehmer eine separate Meßvorrichtung vorgesehen sein.

Die grundsätzliche Funktionsweise der in Fig. 3 dargestellten Vorrichtung entspricht vollständig der bereits beschriebenen Funktionsweise der in Fig. 1 dargestellten Vorrichtung.

Fig. 3 zeigt darüber hinaus zwei optionale Ergänzungen zu der Vorrichtung gemäß Fig. 1. Zum einen ist zwischen dem Meßsignaleingang 10' und dem jeweiligen Bezugssignalanschluß 16', 16'' der Kondensatoren 14', 14" ein Widerstand 19 vorgesehen, der zusammen mit dem Widerstand 15' einen Spannungsteiler für das von dem Meßwertaufnehmer 1' gelieferte Ausgangssignal bildet. Auf diese Weise können die von dem Meßwertaufnehmer 1' gelieferten Spannungswerte an die von der Meßvorrichtung 9 zu verarbeitenden möglichen Spannungswerte angepaßt werden.

Weiter ist der Meßsignalanschluß 13"" mit einer Stromquelle 20 verbunden, so daß der Meßwertaufnehmer 1"" beispielsweise als Ausgangssignal nicht unmittelbar eine Spannung, sondern einen Widerstand liefern kann, wie es beispielsweise bei Temperaturaufnehmern oder mechanischen Aufnehmern der Fall ist. Durch die Stromquelle 20 wird in Verbindung mit dem sich ändernden Widerstand eine Spannung erzeugt, die wiederum in dem Kondensator 14"" in beschriebener Weise gespeichert wird, so daß auch bei solchen passiven Elementen mit einer erfindungsgemäß ausgebildeten Vorrichtung ein vorhandener Offset korrigiert werden kann.

### Bezugszeichenliste

- 1: Meßwertaufnehmer
- 2: erste Meßleitung
- 3: zweite Meßleitung
- 4: Steuergerät
- 5: Leitung
- 6: Signalmasse
- 7: Leitung
- 8: Hauptmasse
- 9: Meßvorrichtung
- 10: Meßsignaleingang
- 11: Steuerausgang
- 12: Schalter
- 13: Meßsignalanschluß
- 14: Signalwertspeicherelement
- 15: Widerstand
- 16: Bezugssignalanschluß
- 17: Widerstand
- 18: Linie
- 19: Widerstand
- Uₛ: Meßsignal
- U_{D}, U₂: Spannungsabfall
- U₁: Eingangssignal
- U_{c}: Kondensatorspannung
- U_{T}: Transistorsteuersignal
- U₁': kompensiertes :Eingangssignal

## Patentansprüche

1. Vorrichtung zur Offsetkompensation bei analogen Signalmessungen mit einer Meßvorrichtung (9) mit einem Meßsignaleingang (10, 10', 10'', 10''', 10'''') zum Messen eines von einem Meßwertaufnehmer (1, 1', 1'', 1"', 1'''') gelieferten analogen Signalwertes (Us) gegenüber einem Haupt-Bezugspunkt (8), mit einem Signalwertspeicherelement (14, 14', 14'', 14''', 14'''') zum Speichern des zu messenden Signalwertes (Us), wobei das Signalwertspeicherelement (14, 14', 14", 14"', 14"") einen Meßsignalanschluß (13, 13', 13", 13'", 13"") und einen Bezugssignalanschluß (16, 16', 16", 16"', 16'''') aufweist und der Meßsignalanschluß (13, 13', 13", 13"', 13"") mit dem Meßsignaleingang (10, 10', 10", 10"', 10"") der Meßvorrichtung (9) verbunden und an eine erste, den Signalwert (Us) führende Meßleitung (2, 2', 2", 2"', 2"") des Meßwertaufnehmers (1, 1', 1", 1"', 1"") anschließbar ist sowie der Bezugssignalanschluß (16, 16', 16", 16''', 16'''') an eine zweite, mit einem Bezugspunkt (6, 6', 6'') des Meßwertaufnehmers (1, 1', 1'', 1"', 1'''') verbundene Meßleitung (3, 3', 3") des Meßwertaufnehmers (1, 1', 1'', 1''', 1'''') anschließbar ist, mit einem Schalter (12, 12', 12''), über den der Bezugssignalanschluß (16, 16', 16'', 16''', 16"") des Signalwertspeicherelements (14, 14', 14'', 14"', 14"") mit dem Haupt-Bezugssignal (8) verbindbar bzw. von diesem trennbar ist, und mit einer Steuervorrichtung (9) zum Ansteuern des Schalters (12, 12', 12").

2. Vorrichtung nach Anspruch 1,
**dadurch gekennzeichnet,**
**daß** die Meßvorrichtung (9) als Spannungsmeßvorrichtung ausgebildet ist.

3. Vorrichtung nach Anspruch 1 oder 2,
**dadurch gekennzeichnet,**
**daß** das Signalwertspeicherelement (14, 14', 14", 14''', 14"") als Kondensator ausgebildet ist.

4. Vorrichtung nach einem der vorhergehenden Ansprüche,
**dadurch gekennzeichnet,**
**daß** der Meßsignalanschluß (13, 13', 13", 13"', 13"") des Signalwertspeicherelements (14, 14', 14", 14"', 14"") an die den Signalwert (Us) führende Meßleitung (2, 2', 2'', 2''', 2"") des Meßwertaufnehmers (1, 1', 1'', 1''', 1"") über einen Widerstand (15, 15', 15", 15''', 15"") anschließbar ist.

5. Vorrichtung nach einem der vorhergehenden Ansprüche,
**dadurch gekennzeichnet,**
**daß** der Bezugssignalanschluß (16, 16', 16'', 16''', 16"") des Signalwertspeicherelements (14, 14', 14'', 14"', 14"") an die mit dem Bezugspunkt (6, 6', 6") des Meßwertaufnehmers (1, 1', 1", 1"', 1"") verbundene Meßleitung (3, 3', 3", 3''', 3'''') des Meßwertaufnehmers (1, 1', 1'', 1''', 1'''') über einen Widerstand (17, 17', 17") anschließbar ist.

6. Vorrichtung nach einem der vorhergehenden Ansprüche,
**dadurch gekennzeichnet,**
**daß** der Schalter (12, 12', 12'') als Transistor ausgebildet ist.

7. Vorrichtung nach einem der vorhergehenden Ansprüche,
**dadurch gekennzeichnet,**
**daß** die Meßvorrichtung und die Steuervorrichtung als Mikroprozessor (9) ausgebildet sind.

8. Vorrichtung nach einem der vorhergehenden Ansprüche,
**dadurch gekennzeichnet,**
**daß** der Meßwertaufnehmer (1, 1', 1'', 1''', 1'''') als Füllstand-, Druck-, Temperatur- oder Sauerstoffmeßvorrichtung, beispielsweise als Lambdasonde ausgebildet ist.

9. Vorrichtung nach einem der vorhergehenden Ansprüche,
**dadurch gekennzeichnet,**
**daß** mehrere Meßwertaufnehmer (1, 1', 1'', 1''', 1'''') und eine entsprechende Anzahl von Signalwertspeicherelementen (14, 14', 14", 14''', 14'''') vorgesehen sind und daß jeweils mehrere Signalwertspeicherelemente (14, 14', 14'', 14''', 14'''') über denselben Schalter (12, 12', 12'') mit dem Haupt-Bezugspunkt (8) verbindbar sind.

10. Meßsystem zum Messen analoger Signalwerte mit zumindest einer Vorrichtung zur Offsetkompensation nach einem der vorhergehenden Ansprüche und mit zumindest einem mit dieser Vorrichtung über die Meßleitungen (2, 2', 2'', 2''', 2'''', 3, 3', 3", 3''', 3"") verbundenen Meßwertaufnehmer (1, 1', 1", 1''', 1"").

11. Verfahren zur Offsetkompensation beim Messen von analogen Signalwerten, insbesondere mit einer Vorrichtung nach einem der Ansprüche 1 bis 10, bei dem der zu messende Signalwert vor dem Meßvorgang in einem Signalwertspeicherelement massefrei gespeichert wird und während des Meßvorgangs das Signalwertspeicherelement gegen Masse gelegt und der gespeicherte Signalwert gemessen wird.

12. Verwendung einer Vorrichtung nach einem der Ansprüche 1 bis 10 zur Offsetkompensation bei der Messung von Signalwerten in einem Kraftfahrzeug.

## Claims

1. Device for offset compensation in analogue signal measurements having a measuring device (9) with a measurement signal input (10, 10', 10", 10"', 10"") for measuring an analogue signal value (Uₛ) supplied by a measured value transducer (1, 1', 1", 1"', 1"") with respect to a main reference point (8), having a signal value storage element (14, 14', 14", 14"', 14"") for storing the signal value (Uₛ) to be measured, wherein the signal value storage element (14, 14', 14", 14"', 14"") has a measurement signal connection (13, 13', 13", 13"', 13"") and a reference signal connection (16, 16', 16", 16"', 16"") and the measurement signal connection (13, 13', 13", 13"', 13"") is connected to the measurement signal input (10, 10', 10", 10"', 10"") of the measuring device (9) and is connectable to a first measurement lead (2, 2', 2", 2"', 2"") of the measured value transducer (1, 1', 1", 1"', 1"") carrying the signal value (Uₛ) and the reference signal connection (16, 16', 16", 16"', 16"") is connectable to a second measurement lead (3, 3', 3") of the measured value transducer (1, 1', 1", 1"', 1"") connected to a reference point (6, 6', 6") of the measured value transducer (1, 1', 1", 1"', 1""), having a switch (12, 12', 12") by means of which the reference signal connection (16, 16', 16", 16"', 16"") of the signal value storage element (14, 14', 14", 14"', 14"") is connectable to the main reference signal (8) or disconnectable from the latter and having a control device (9) for controlling the switch (12, 12', 12").

2. Device according to claim 1, **characterised in that** the measuring device (9) is constructed as a voltage measuring device.

3. Device according to claim 1 or 2, **characterised in that** the signal value storage element (14, 14', 14", 14"', 14"") is constructed in the form of a capacitor.

4. Device according to one of the preceding claims, **characterised in that** the measurement signal connection (13, 13', 13", 13"', 13"") of the signal value storage element (14, 14', 14", 14"', 14"") is connectable via a resistor (15, 15', 15", 15"', 15"") to the measurement lead (2, 2', 2", 2"', 2"") of the measured value. transducer (1, 1', 1", 1"', 1"") carrying the signal value (Us).

5. Device according to one of the preceding claims, **characterised in that** the reference signal connection (16, 16', 16", 16"', 16"") of the signal value storage element (14, 14', 14", 14"', 14"") is connectable via a resistor (17, 17', 17") to the measurement lead (3, 3', 3", 3"', 3"") of the measured value transducer (1, 1', 1", 1"', 1"") connected to the reference point (6, 6', 6").

6. Device according to one of the preceding claims, **characterised in that** the switch (12, 12', 12") is constructed as a transistor.

7. Device according to one of the preceding claims, **characterised in that** the measuring device and the control device are constructed as a microprocessor (9).

8. Device according to one of the preceding claims, **characterised in that** the measured value transducer (1, 1', 1", 1"', 1"") is constructed as a filling level, pressure, temperature or oxygen measuring device, for example as a lambda probe.

9. Device according to one of the preceding claims, **characterised in that** a plurality of measured value transducers (1, 1', 1", 1''', 1"") and a corresponding number of signal value storage elements (14, 14', 14", 14"', 14"") are provided and that in each case a plurality of signal value storage elements (14, 14', 14", 14"', 14"") are connectable via the same switch (12, 12', 12") to the main reference point (8).

10. Measurement system for measuring analogue signal values having at least one device for offset compensation according to one of the preceding claims and having at least one measured value transducer (1, 1', 1", 1"', 1"") connected to this device through the measurement leads (2, 2', 2", 2"', 2"", 3, 3', 3", 3"', 3"").

11. Method for offset compensation in the measurement of analogue signal values, in particular using a device according to one of claims 1 to 10, in which the signal value to be measured is stored without earthing in a signal value storage element prior to the measurement operation and during the measurement operation the signal value storage element is earthed and the stored signal value is measured.

12. Use of a device according to one of claims 1 to 10 for offset compensation in the measurement of signal values in a motor vehicle.

## Revendications

1. Dispositif pour la compensation d'offset dans la mesure de signaux analogiques comportant un dispositif de mesure (9) avec une entrée de signal de mesure (10, 10', 10", 10''', 10"") pour la mesure d'une valeur de signal analogique fournie par un transducteur (1, 1', 1", 1''', 1"") par rapport à un point de référence principal (8), comportant un élément de stockage de valeur de signal (14, 14', 14", 14''', 14"") pour le stockage de la valeur de signal à mesurer (Uₛ), l'élément de stockage de valeur de signal (14, 14', 14", 14"', 14"") présentant une connexion de signal de mesure (13, 13', 13", 13"', 13"") et une connexion de signal de référence (16, 16', 16", 16''', 16'''') et la connexion de signal de mesure (13, 13', 13", 13"', 13"") étant raccordée à l'entrée de signal de mesure (10, 10', 10", 10''', 10"") du dispositif de mesure (9) et pouvant être connectée à une première ligne de mesure (2, 2', 2", 2''', 2"") du transducteur (1, 1', 1", 1''', 1 "") parcourue par la valeur de mesure, et la connexion de signal de référence (16, 16', 16", 16"', 16"") pouvant être connectée à une deuxième ligne de mesure du transducteur (3, 3', 3") raccordée à un point de référence (6, 6', 6") du transducteur (1, 1', 1", 1''', 1''''), comportant un commutateur (12, 12', 12") par l'intermédiaire duquel la connexion de signal de référence (16, 16', 16", 16''', 16"") de l'élément de stockage de valeur de signal (14, 14', 14", 14''', 14'''') peut être raccordée au et/ou séparée du point de référence principal (8), et comportant un dispositif de commande (9) pour la commande du commutateur (12, 12', 12").

2. Dispositif selon la revendication 1, **caractérisé en ce que** le dispositif de mesure (9) est conçu sous la forme d'un dispositif de mesure de tension.

3. Dispositif selon la revendication 1 ou 2, **caractérisé en ce que** l'élément de stockage de valeur de signal (14, 14', 14", 14''', 14'''') est conçu sous la forme d'un condensateur.

4. Dispositif selon une des revendications précédentes, **caractérisé en ce que** la connexion de signal de mesure (13, 13', 13", 13''', 13"") de l'élément de stockage de valeur de signal (14, 14', 14", 14''', 14'''') à la ligne de mesure (2, 2', 2", 2''', 2'''') du transducteur (1, 1', 1", 1''', 1"") parcourue par la valeur de mesure (Us) peut être connectée par l'intermédiaire d'une résistance (15, 15', 15", 15''' 15'''').

5. Dispositif selon une des revendications précédentes, **caractérisé en ce que** la connexion de signal de référence (16, 16', 16", 16''', 16"") de l'élément de stockage de valeur de signal (14, 14', 14", 14''', 14'''') peut être connectée à la ligne de mesure (3, 3', 3", 3"', 3"") du transducteur (1, 1', 1", 1''', 1"") raccordée au point de référence (6, 6', 6") du transducteur (1,1', 1", 1''', 1'''') par l'intermédiaire d'une résistance (17, 17', 17").

6. Dispositif selon une des revendications précédentes, **caractérisé en ce que** le commutateur (12, 12', 12") est conçu sous la forme d'un transistor.

7. Dispositif selon une des revendications précédentes, **caractérisé en ce que** le dispositif de mesure et le dispositif de commande sont conçus sous la forme d'un microprocesseur (9).

8. Dispositif selon une des revendications précédentes, **caractérisé en ce que** le transducteur (1, 1', 1", 1"', 1'''') est conçu sous la forme d'un dispositif de mesure de niveau, pression, température ou oxygène, par exemple une sonde lambda.

9. Dispositif selon une des revendications précédentes, **caractérisé en ce que** sont prévus plusieurs transducteurs (1, 1', 1", 1''', 1''''), et un nombre correspondant d'éléments de stockage de valeur de signal (14, 14', 14", 14''', 14''''), et **en ce que** les plusieurs éléments de stockage de valeur de signal (14, 14', 14", 14''', 14'''') peuvent être raccordés au point de référence principal (8) par le même commutateur (12, 12', 12").

10. Système de mesure pour la mesure de valeurs de signal analogique comportant au moins un dispositif pour la compensation d'offset selon une des revendications précédentes, et comportant au moins un transducteur (1, 1', 1", 1''', 1'''') connecté à ce dispositif par les lignes de mesure (2, 2', 2", 2''', 2'''', 3, 3', 3",3''',3'''').

11. Procédé pour la compensation d'offset dans la mesure de valeurs de signal analogique comportant en particulier un dispositif selon une des revendications 1 à 10, dans lequel la valeur de signal à mesurer est stockée sans masse avant le processus de mesure dans un élément de stockage de valeur de signal et en ce que pendant le processus de mesure, l'élément de stockage de valeur de signal est mis en opposition à la masse et la valeur de signal stockée est mesurée.

12. Utilisation d'un dispositif selon une des revendications 1 à 10 pour la compensation d'offset dans la mesure de valeurs de signal analogique dans un véhicule automobile.
